# FASCICULE DE BREVET EUROPEEN

(11) **EP 2 562 804 B1**
(45) Date de publication et mention de la délivrance du brevet: **18.06.2014**
(21) Numéro de dépôt: 12181061.8
(22) Date de dépôt: 20.08.2012
(51) Int. Cl.: H01L 21/84, H01L 27/12, H01L 21/285, H01L 29/66, H01L 21/8238, H01L 29/78, H01L 27/092, H01L 29/10

(54) **PROCEDE DE REALISATION D'UN DISPOSITIF A TRANSISTORS CONTRAINTS PAR SILICIURATION DES ZONES DE SOURCE ET DE DRAIN, ET DISPOSITIF**
Herstellungsverfahren für ein Bauelement mit durch Silizidierung von Source- und Drain-Gebieten vorgespannten Transistoren, und Bauelement
Method for making a device comprising transistors strained by silicidation of source and drain regions, and device

(30) Priorité: 25.08.2011 FR 1157532
(43) Date de publication de la demande: 27.02.2013
(73) Titulaire: Commissariat à l'Énergie Atomique et aux Énergies Alternatives, 75015 Paris (FR)
(72) Inventeur: Nemouchi, Fabrice, 38430 MOIRANS (FR); Gergaud, Patrice, 38500 LA BUISSE (FR); Poiroux, Thierry, 38500 VOIRON (FR); Previtali, Bernard, 38100 GRENOBLE (FR)
(74) Mandataire: Ilgart, Jean-Christophe

(56) Documents cités:
- JP-A- 11 067 694
- US-A- 5 989 965
- US-A1- 2003 045 039
- US-A1- 2006 220 113
- US-A1- 2007 066 001
- US-A1- 2009 050 972
- US-A1- 2009 104 746
- US-A1- 2011 065 245
- US-A1- 2011 084 320
- US-A1- 2011 159 654
- "APPLYING MECHANICAL STRESS TO IMPROVE MOS SEMICONDUCTOR PERFORMANCE", IBM TECHNICAL DISCLOSURE BULLETIN, INTERNATIONAL BUSINESS MACHINES CORP. (THORNWOOD), US, vol. 30, no. 9, 1 février 1988 (1988-02-01), pages 330-333, XP000104874, ISSN: 0018-8689

## Description

### DOMAINE TECHNIQUE

La présente demande concerne le domaine des dispositifs microélectroniques à transistors, et en particulier celui des transistors à canal contraint comportant des zones de source et de drains siliciurées

L'invention prévoit un procédé de réalisation d'un dispositif à transistors contraints dans lequel le canal de certains transistors sont contraints notamment par des zones de source et de drain siliciurées.

Elle trouve notamment des applications en particulier dans la réalisation de transistors de taille inférieure à 22 nm.

### ÉTAT DE LA TECHNIQUE ANTÉRIEURE

Les performances en courant des transistors à effet de champ sont liées notamment à la mobilité des porteurs de charge, c'est à dire des électrons pour les transistors de type N et des trous pour les transistors de type P.

Dans le canal d'un transistor, la vitesse de déplacement des porteurs de charge peut être améliorée en contraignant ce dernier. Appliquer une contrainte permet de réaliser une distorsion du réseau cristallin du matériau semi-conducteur et de modifier sa structure de bande et en particulier les propriétés de transport de charges.

Lorsqu'un canal est contraint en compression, cela favorise le déplacement de trous dans ce dernier tandis que lorsqu'un canal est contraint en tension, ce sont les électrons dont le déplacement est favorisé.

Pour obtenir un gain en performance des transistors PMOS on cherche donc généralement à les contraindre en compression, tandis qu'un gain en performance des transistors NMOS est obtenu en appliquant une contrainte en tension sur leurs canaux.

Différentes méthodes existent pour induire un état de contrainte dans le canal d'un transistor.

Il est connu d'appliquer une contrainte sur le canal de transistors en déposant une couche de contrainte, prévue pour appliquer un type donné de contrainte, par exemple une contrainte en tension, sur les zones de source et de drain ainsi que sur la grille de ces derniers.

Cependant, dans le cas où l'on réalise un dispositif comprenant des transistors de types différents par exemple à la fois des transistors de type PMOS et des transistors de type NMOS, la contrainte est appliquée par la couche externe indifféremment sur tous les transistors, ce qui peut nuire au fonctionnement de certains transistors, par exemple aux transistors PMOS lorsque cette couche externe est prévue pour appliquer une contrainte en tension.

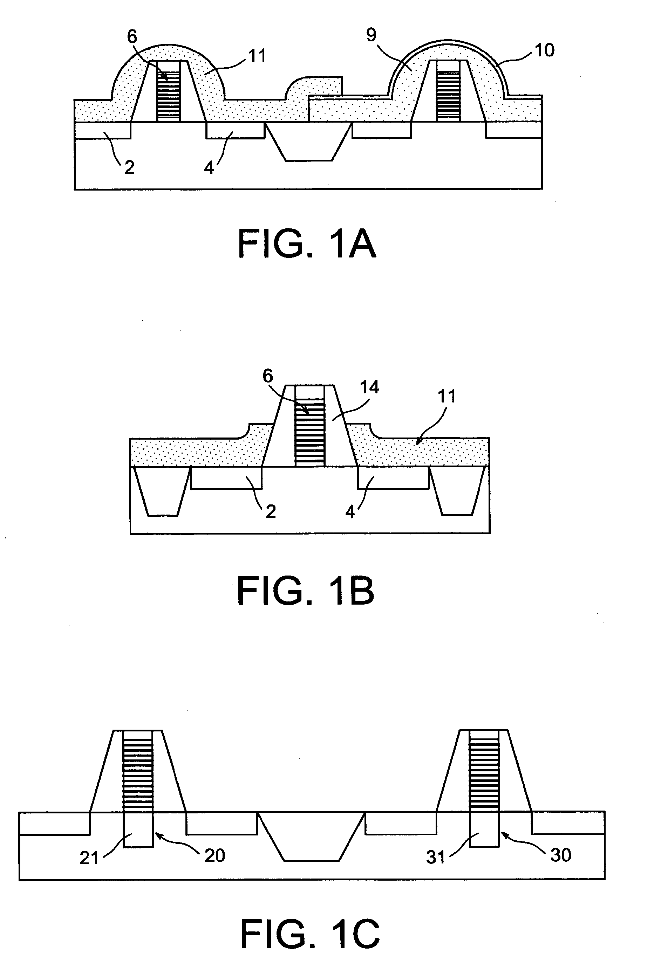

Les documents US 2007/0099360 A1 et US 2007/0287240 A1, divulguent des procédés de réalisation de transistors à canaux contraint à l'aide d'une couche de nitrure de silicium 11 que l'on vient déposer sur les zones de source 2 et de drain 4 ainsi que sur la grille 6 du transistor (figures 1A et 1B).

La couche de contrainte à base de nitrure de silicium 11 peut être conservée sur la grille 6 (figure 1A) ou retirée du dessus de la grille 6 de manière à n'être en contact qu'avec les espaceurs 14 formés sur les flancs de la grille (figure 1B).

Pour permettre de former un dispositif doté à la fois de transistors contraints en tension et de transistors contraints en compression, on forme tout d'abord une première couche de nitrure de silicium 9 destinée à contraindre en tension sur l'ensemble des transistors.

Cette première couche de nitrure de silicium 9 est recouverte d'une couche d'arrêt de gravure 10, puis est retirée par gravure au dessus des transistors que l'on souhaite contraindre en compression. on dépose ensuite une deuxième couche de nitrure de silicium 11 destinée à contraindre en compression. Cette deuxième couche 11, est ensuite retirée de l'ensemble des transistors que l'on souhaite contraindre en tension, par gravure avec arrêt sur la couche d'arrêt 10 (figure 1A).

Il est également connu de former des transistors à canal contraint par une couche sous-jacente.

Le document US 2009/0085125A1, divulgue un dispositif doté d'un transistor dont le canal 21 est contraint par croissance épitaxiée d'une couche de matériau 21 ayant des paramètres de maille différents de celui du Si (figure 1C). Un tel matériau 21 peut être par exemple à base de SiGe sur lequel on vient former un diélectrique de grille 20 par croissance d'une couche de Si suivie d'une oxydation thermique du Si. Dans ce cas, on peut obtenir un canal 21 contraint en compression pour réaliser un transistor pMOS.

Le dispositif comprend un autre transistor dont le canal 31 est contraint par croissance épitaxiée d'une autre couche de matériau 31. Un tel matériau 31 peut être par exemple à base de SiC sur lequel on vient former un diélectrique de grille 30 par croissance d'un couche de Si suivie d'une oxydation thermique de cette couche de Si. Dans ce cas, on peut obtenir un canal 31 contraint en tension pour réaliser un transistor nMOS (figure 1C).

Un tel procédé nécessite de nombreuses étapes de photolithographie, de gravures ainsi que de dépôts par épitaxie pour mettre en oeuvre un tel dispositif.

Un exemple de procédé de réalisation d'un transistor à canal contraint est donné dans le document US 2009/0050972 A1.

Un autre exemple de procédé de réalisation d'un transistor à canal contraint est donné dans le document US 2011/0084320 A1.

Il se pose le problème de réaliser un dispositif doté d'au moins un transistor contraint en compression.

### EXPOSÉ DE L'INVENTION

L'invention concerne un procédé selon la revendication 1.

Un procédé de réalisation d'un dispositif microélectronique à transistors comprend des étapes de :
a) formation d'une couche barrière à base d'un matériau donné sur des premières zones semi-conductrices situées de part et d'autre d'un premier bloc de grille d'un premier transistor, ledit matériau donné étant différent de celui desdites premières zones semi-conductrices,
b) former des ouvertures traversant la couche barrière, une ou plusieurs ouvertures données dévoilant les premières zones semi-conductrices,
c) dépôt d'un matériau métallique à travers lesdites ouvertures , suivi d'un recuit, de manière à former des zones d'alliage de métal et de semi-conducteur, le volume de matériau métallique déposé sur les premières zones semi-conductrices, ainsi que la durée du recuit étant choisis de manière à former des premières zones d'alliage de métal et de semi-conducteur exerçant une contrainte en compression sur une zone de canal dudit premier transistor.

Les zones d'alliage de métal et de semi-conducteur réalisées à l'étape c) sont confinées par le biais de ladite couche barrière.

La couche barrière peut être prévue de manière à empêcher une diffusion de métal lors de l'étape c).

Une telle couche barrière peut permettre de conserver la contrainte exercée par les premières zones d'alliage de métal et de semi-conducteur, par rapport à un procédé dans lequel on formerait des zones d'alliage métal-semi-conducteur sans couche barrière.

Ainsi, la couche barrière peut être choisie à base d'un matériau qui n'est pas susceptible de réagir avec le matériau déposé à l'étape c).

Pour éviter une réaction avec le matériau métallique, la couche barrière peut être de préférence à base d'un matériau qui n'est pas semi-conducteur.

Afin d'éviter un court circuit, la couche barrière peut être de préférence à base d'un matériau qui n'est ni métallique ni formé d'un alliage de métal et de semi-conducteur.

La couche barrière peut être ainsi à base d'un matériau diélectrique.

La couche barrière peut être à base d'un matériau permettant d'exercer une contrainte sur le premier transistor.

Selon une possibilité de mise en oeuvre, la couche barrière peut être à base de SiₓN_{y} qui est un matériau diélectrique susceptible d'exercer une contrainte sur le premier transistor.

Ainsi, selon l'invention, on forme dans des zones semi-conductrices de source et de drain d'un transistor, des zones d'alliage de métal et de semi-conducteur par dépôt de métal et recuit (procédé de siliciuration). Ces zones viennent exercer une contrainte en compression notamment sur la zone de canal du premier transistor.

La taille des ouvertures est de préférence choisie suffisamment faible pour permettre de conserver la contrainte induite par siliciuration. Les ouvertures peuvent ainsi avoir un diamètre compris entre 10 et 50 nanomètres, en particulier lorsque la grille du premier transistor a une dimension critique ou une largeur inférieure à 20 nanomètres.

A l'étape a), la couche barrière peut être également formée sur des deuxièmes zones semi-conductrices situées de part et d'autre d'un deuxième bloc de grille d'un deuxième transistor, une couche sacrificielle étant prévue entre ladite couche de matériau donné et lesdites deuxièmes zones semi-conductrices du deuxième transistor, tandis qu'à l'étape b), parmi les ouvertures traversant la couche barrière, une ou plusieurs ouvertures données dévoilent les deuxièmes zones semi-conductrices. Le procédé peut alors comprendre en outre entre l'étape b) et l'étape c), le retrait de la couche sacrificielle par gravure à travers lesdites ouvertures laissant ainsi des cavités, à l'étape c), ledit dépôt métallique et ledit recuit étant réalisés de manière à former des deuxièmes zones d'alliage de métal et de semi-conducteur comblant partiellement lesdites cavités, un espace étant conservé entre lesdites deuxièmes zones d'alliage de métal et de semi-conducteur et ladite couche barrière.

Ainsi, selon un aspect de l'invention, on forme dans des deuxièmes zones semi-conductrices de source et de drain d'un deuxième transistor, des zones d'alliage de métal et de semi-conducteur par dépôt de métal et recuit. La gravure d'une couche sacrificielle prévue sur une partie desdites deuxièmes zones semi-conductrices permet de former des cavités qui sont remplies partiellement lors de la formation de zones d'alliage de métal et de semi-conducteur, de sorte que ces zones d'alliage de métal et de semi-conducteur n'exercent pas de contrainte en compression sur le deuxième ou que cette contrainte est limitée.

On peut ainsi réaliser des transistors contraints différemment sur un même support.

Selon une possibilité de mise en oeuvre, le premier bloc de grille et le deuxième de bloc de grille peuvent reposer sur une couche semi-conductrice, les premières zones semi-conductrices et/ou les deuxièmes zones semi-conductrices étant formées par croissance sur ladite couche semi-conductrice.

Préalablement à ladite croissance : un amincissement de ladite couche semi-conductrice dans des zones situées de part et d'autres dudit premier bloc de grille et/ou de dudit deuxième bloc de grille peut être réalisé.

Cela permet, d'obtenir par la suite, après croissance, les premières zone semi-conductrices en contact avec une zone de la couche semi-conductrice destinée à former un canal du transistor du premier type et/ou les deuxièmes zone semi-conductrices en contact avec une zone de la couche semi-conductrice destinée à former un canal du transistor du deuxième type.

Selon une possibilité de mise en oeuvre du procédé, les premières zones semi-conductrices peuvent être formées d'un matériau semi-conducteur prévu pour contraindre en compression ladite couche semi-conductrice sur laquelle repose ledit premier bloc de grille. Les premières zones semi-conductrices peuvent être formées par exemple à base de SiGe en particulier lorsque la couche semi-conductrice est à base de Si.

Dans le cas où un amincissement de cette couche semi-conductrice a été réalisé au préalable, une contrainte en compression peut être exercée sur la zone de canal sur laquelle repose le premier bloc de grille.

Selon une possibilité de mise en oeuvre du procédé, les deuxièmes zones semi-conductrices peuvent être formées d'un matériau semi-conducteur prévu pour contraindre en tension ladite couche semi-conductrice sur laquelle repose ledit deuxième bloc de grille. Les deuxièmes zones semi-conductrices peuvent être formées par exemple à base de SiC en particulier lorsque la couche semi-conductrice est à base de Si.

Dans le cas où un amincissement de cette couche semi-conductrice a été réalisé au préalable, une contrainte en tension peut être exercée sur la zone de canal sur laquelle repose le deuxième bloc de grille.

Préalablement à l'étape a), des espaceurs isolants peuvent être formés contre ledit premier bloc de grille et ledit deuxième bloc de grille. Dans ce cas, ladite couche de contrainte peut reposer sur lesdits espaceurs.

Selon une possibilité de mise en oeuvre, ladite couche barrière est formée à l'étape a) de manière à recouvrir le premier bloc de grille et de manière à contraindre le transistor du premier type.

Selon une possibilité de mise en oeuvre, le premier bloc de grille et/ou ledit deuxième bloc de grille sont à base d'au moins un matériau sacrificiel.

Le procédé peut alors comprendre en outre, après l'étape c), des étapes:
- d'ouverture dans la couche barrière sur ledit premier bloc de grille et/ou sur ledit deuxième bloc de grille de manière à dévoiler ledit matériau sacrificiel,
- retrait dudit matériau de grille sacrificiel,
- remplacement dudit matériau sacrificiel par au moins un autre matériau de grille.

La présente invention concerne également un dispositif obtenu à l'aide d'un tel procédé.

La présente invention concerne également un dispositif selon la revendication 12. Un dispositif microélectronique à transistor(s) comprend : des premières zones semi-conductrices situées de part et d'autre d'un premier bloc de grille d'un premier transistor recouvertes d'une couche barrière à base d'un matériau donné sur ledit matériau donné différent de celui desdites premières zones semi-conductrices, des ouvertures traversant la couche barrière, une ou plusieurs ouvertures données dévoilant les premières zones semi-conductrices, des premières zones d'alliage de métal et de semi-conducteur étant formées à travers les ouvertures et agencées de manière à exercer une contrainte en compression sur une zone de canal dudit premier transistor.

Selon une possibilité de mise en oeuvre du dispositif microélectronique, ladite couche barrière peut recouvrir également des deuxièmes zones semi-conductrices situées de part et d'autre d'un deuxième bloc de grille d'un deuxième transistor, une couche sacrificielle étant prévue entre ladite couche de matériau donné et lesdites deuxièmes zones semi-conductrices du transistor du deuxième type, une ou plusieurs ouvertures données formées dans la couche barrière dévoilant les deuxièmes zones semi-conductrices, un espace étant prévu entre lesdites deuxièmes zones d'alliage de métal et de semi-conducteur et ladite couche barrière.

Ainsi le premier transistor et le deuxième transistor sont contraints différemment l'un par rapport à l'autre.

La couche barrière peut être une couche de contrainte.

Les deuxièmes zones semi-conductrices peuvent être formées d'un matériau semi-conducteur, tel que du SiC, prévu pour contraindre en tension une couche semi-conductrice sur laquelle repose ledit deuxième bloc de grille.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
- les figures 1A-1C donnent des exemples de dispositifs microélectronique à transistors suivant l'art antérieur dotés de transistors PMOS et NMOS contraints respectivement, en compression et en tension,
- les figures 2A-2K illustrent un exemple de procédé suivant l'invention de dispositifs microélectronique à transistors dont le canal est contraint,
- les figures 3A-3B illustrent une variante de procédé lors de laquelle on forme des grilles sacrificielles puis on remplace ces grilles sacrificielles par un empilement de matériaux de grille,
- les figures 4A-4B illustrent une variante de procédé lors de laquelle on conserve le métal déposé après siliciuration,
- la figure 5, illustre une variation d'une force dans une zone de siliciure lors de sa formation en fonction du temps de recuit,
- la figure 6, illustre une variation des forces dans une zone de siliciure au cours de sa croissance pour différentes valeurs de coefficients de diffusion,
- la figure 7, illustre des forces dans une zone de siliciure au cours de sa croissance pour différentes valeurs de taux de relaxation à coefficient de diffusion Kd constant.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

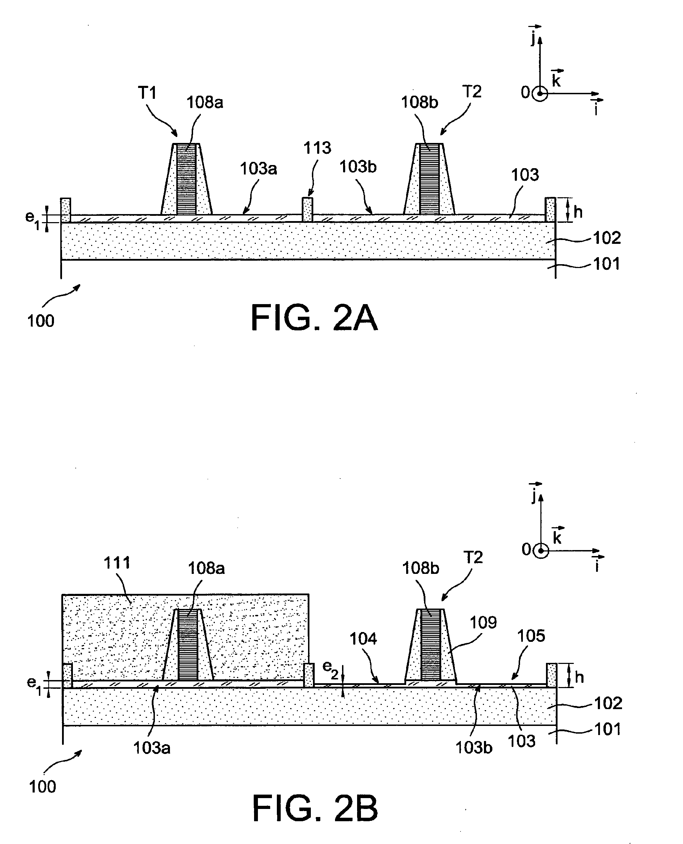

Un exemple de procédé suivant l'invention, de réalisation d'un dispositif microélectronique à transistors dont le canal est contraint, va à présent être décrit en liaison avec les figures 2A-2K.

Le matériau de départ peut être un substrat 100, par exemple de type SOI (SOI pour Silicon On Insulator ou « silicium sur isolant ») formé d'une couche de support 101 semi-conductrice, d'une couche isolante 102 recouvrant la couche de support 101 et d'une fine couche semi-conductrice 103 sur la couche isolante 102. La couche isolante 102 du substrat 100 peut être par exemple un oxyde de silicium enterré de type ultra mince ou UTBox (UTBox pour « Ultra Thin Burried oxide ») d'une épaisseur comprise par exemple entre 5 nm et 145 nm.

Sur le support 100, une première grille 108a d'un transistor T1 d'un premier type, par exemple de type PMOS reposant sur une première région 103a de la fine couche semi-conductrice 103 ainsi qu'une deuxième grille 108b d'un transistor T₂ d'un deuxième type, par exemple de type NMOS, reposant sur une deuxième région 103b de la fine couche semi-conductrice 103, sont formées. Une incorporation d'éléments dopants peut avoir été préalablement réalisée dans la fine couche semi-conductrice 103.

Des zones d'isolation 113 de type STI (STI pour « shallow Trench Isolation » ou tranchées d'isolation peu profondes) peuvent être également prévues entre les transistors T1, T2, afin d'isoler électriquement ces derniers entre eux (figure 2A).

Ces zones d'isolation 113 STI peuvent être prévues de manière à dépasser de l'épaisseur de la fine couche semi-conductrice 103. La fine couche semi-conductrice 103 peut être prévue avec une épaisseur e1 (mesurée sur la figure 2B dans une direction parallèle au vecteur *̅j̅*̅ du repère orthogonal [O*; i̅ ; j̅ ; k̅* ] ) comprise par exemple entre 5 nm et 50 nm et préférentiellement entre 5 nm et 10 nm, tandis que les zones d'isolation 113 STI peuvent être prévues avec une hauteur h (également mesurée sur la figure 2B dans une direction parallèle au vecteur *j̅*) comprise par exemple 10 nm et 100 nm.

Les zones d'isolation 113 STI peuvent être prévues de manière à dépasser de l'épaisseur de la fine couche semi-conductrice 103 d'une épaisseur E = h - e1 prédéterminée, prévue notamment en fonction de celles de zones semi-conductrices destinées à être réalisées ultérieurement et prévues pour former des régions de source et de drain des transistors T1 et T2.

Ensuite, on peut retirer des portions de la deuxième région 103b de part et d'autre de la deuxième grille 108b, de manière à amincir la deuxième région 103b semi-conductrice de la couche semi-conductrice 103 dans des zones 104, 105, destinées à former une source et un drain du deuxième transistor T2. Après amincissement, les flancs d'une zone de canal située sous la grille 108b sont dévoilés.

Pour cela, des étapes de dépôt d'une couche de masquage, par exemple une couche de masque dur à base de nitrure de silicium, puis de photolithographie et de gravure, peuvent être prévues pour former un masque dur 111 recouvrant la première grille 108a ainsi que la première région semi-conductrice 103a. La seconde grille 108b et la seconde région semi-conductrice 103b sont quant à elles dévoilées.

L'amincissement des zones 104, 105 de la deuxième région semi-conductrice 103b peut être effectué de manière à conserver une épaisseur comprise par exemple entre 3 nm et 10 nm de matériau semi-conducteur. Lors de l'amincissement de la deuxième région semi-conductrice 103b, la zone de canal située sous la deuxième grille 108b peut être protégée par une zone de diélectrique de grille, ainsi que par des espaceurs isolants 109 accolés contre la deuxième grille 108b. On peut ainsi conserver une épaisseur e₁ pour la zone de canal supérieure à celle e₂ des zones 104, 105 de la région semi-conductrice 103b destinées à appartenir, respectivement, à une zone de source et à une zone de drain du deuxième transistor T₂ (figure 2B).

Selon une variante de réalisation (non représentée) la hauteur h des zones d'isolation 113 est prévue en rapport avec l'épaisseur e₁ de la fine couche semi-conductrice 103 de sorte que h-e₁ est suffisante pour permettre de faire croitre des zones semi-conductrices sur la deuxième région 103b en particulier sans dépasser du sommet des zones d'isolation 113. Pour cette variante, un amincissement de la deuxième région 103b n'est pas nécessairement effectué.

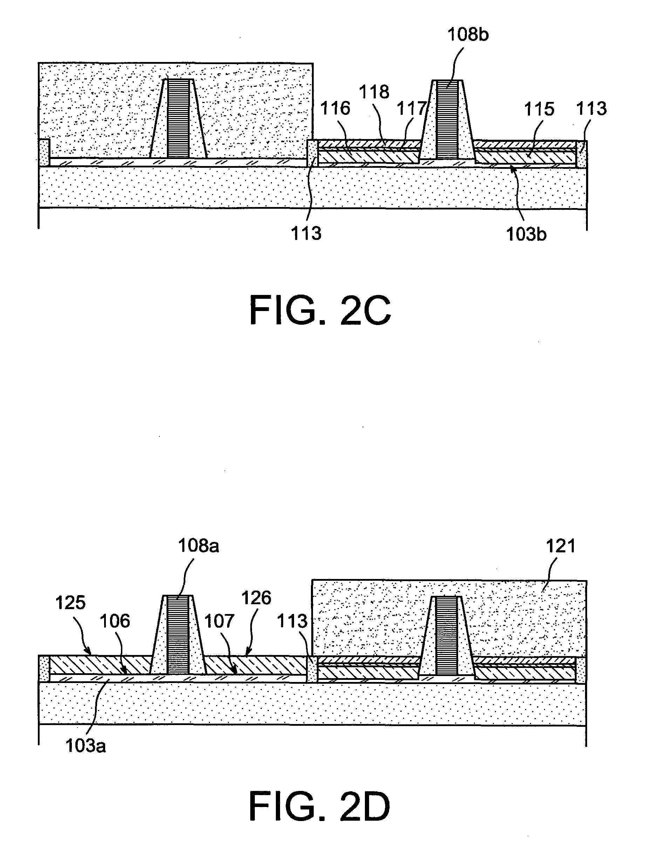

Ensuite, on forme des zones semi-conductrices 115, 116 sur la deuxième région semi-conductrice 103b, de part et d'autre de la grille (figure 2C).

Ces zones semi-conductrices 115, 116 peuvent être réalisées par une croissance par épitaxie.

Le matériau semi-conducteur des zones 115, 116 peut être choisi de manière à avoir un paramètre de maille inférieur à celui du matériau semi-conducteur de la deuxième région semi-conductrice 103b. Dans ce cas, les zones semi-conductrices 115, 116 réalisées exercent une contrainte sur la zone semi-conductrice 103b, en particulier une contrainte en tension sur la zone de canal du transistor T₂.

Lorsque le matériau semi-conducteur de la couche semi-conductrice 103 est du silicium, le matériau des zones semi-conductrices 115, 116 peut être par exemple du SiC dont l'épaisseur peut être comprise par exemple entre 5 nm et 30 nm.

Puis, une couche d'arrêt 117 de gravure est déposée sur les zones semi-conductrices 115, 116. Cette couche d'arrêt 117 peut être formée par exemple à base de SiGe selon une épaisseur par exemple de l'ordre de 1 nm.

On forme ensuite une couche sacrificielle 118. Le matériau de la couche sacrificielle 118 peut être un matériau choisi de manière à pouvoir être gravé sélectivement vis-à-vis de celui d'une couche dite « de contrainte », destinée à être réalisée ultérieurement.

La couche sacrificielle 118 peut être également formée avec une épaisseur prédéterminée en fonction d'une étape de siliciuration destinée à être réalisée ultérieurement. La couche sacrificielle 118 peut par exemple être formée à base de Si selon une épaisseur par exemple comprise entre 5 nm et 10 nm (Figure 2C).

Selon une possibilité de mise en oeuvre, l'épaisseur cumulée de chaque zone semi-conductrice 115, 116, de la couche d' arrêt de gravure 117 et de la couche sacrificielle 118 peut être prévue de sorte que le sommet des zones d'isolation 113 et une face dévoilée de la couche sacrificielle 117 sont à la même hauteur ou sensiblement à la même hauteur.

Le masque dur 111 peut être ensuite retiré.

Puis, des étapes de dépôt d'une couche de masquage, par exemple une couche de masque dur à base de nitrure de silicium, puis de photolithographie et de gravure, peuvent être prévues pour former un autre masque dur 121 recouvrant la deuxième grille 108b ainsi que les zones semi-conductrices 115, 116. La première grille 108a et la première région semi-conductrice 103a sont quant à elles dévoilées.

Une étape d'amincissement de zones 106, 107 de la première région semi-conductrice 103a situées de part et d'autre de la grille 108a du premier transistor T1 peut éventuellement être également effectuée.

Ensuite, on forme des zones semi-conductrices 125, 126 sur la première région semi-conductrice 103a. Ces zones semi-conductrices 125, 126 peuvent être réalisées par épitaxie, avec une épaisseur comprise par exemple entre 5 nm et 30 nm (figure 2D).

Le matériau des zones 125, 126 peut être un semi-conducteur choisi de manière à avoir un paramètre de maille supérieur à celui du matériau semi-conducteur de la première région semi-conductrice 103a.

Dans ce cas, les zones semi-conductrices 125, 126 exercent une contrainte en compression sur la région semi-conductrice 103a, et en particulier sur la zone de canal du transistor T₁.

Lorsque le matériau semi-conducteur de la couche semi-conductrice 103 est du silicium, le matériau des zones semi-conductrices 125, 126 peut être par exemple du SiGe dont l'épaisseur peut être comprise par exemple entre 5 nm et 30 nm.

On réalise ensuite un retrait dudit autre masque dur 121.

Puis, on forme une couche 130 dite « barrière ».

Dans ce cas, cette couche 130 barrière peut être à base d'un matériau donné différent de celui des premières zones semi-conductrices. La couche barrière 130 est choisie de sorte que lors d'une réalisation de zones d'alliage de métal et de semi-conducteur, en particulier d'une siliciuration destinée à être réalisée ultérieurement sur les premières zones semi-conductrices, elle ne réagisse pas avec le métal déposé lors de cette siliciuration et empêche une diffusion de métal et une expansion de zones d'alliage de métal et de semi-conducteur. Cela permet de conserver voire d'accroitre la contrainte par un effet de confinement du siliciure.

Pour cela, la couche barrière 130 peut être prévue à base d'un matériau qui est inerte vis-à-vis du métal destiné à être déposé lors d'une étape ultérieure de siliciuration. Ainsi, de préférence, le matériau donné n'est pas semi-conducteur.

Pour éviter des phénomènes de court circuit, le matériau donné de la couche barrière 130 n'est de préférence pas métallique ou à base de métal.

La couche barrière 130 peut être à base d'un matériau diélectrique tel que par exemple du Si₃N₄.

La couche barrière 130 peut être également prévue à base d'un matériau donné permettant d'exercer une contrainte sur le canal de certains transistors du dispositif. La couche 130 peut être prévue en particulier pour exercer une contrainte sur le canal de transistors d'un type donné, par exemple sur le premier transistor T₁ de type PMOS. Dans ce cas, la couche barrière 130 peut être par exemple à base d'un nitrure de silicium tel que du Si₃N₄.

Cette couche barrière 130 peut être également prévue pour jouer le rôle de couche d'arrêt de gravure pour au moins une étape de gravure destinée à être réalisée ultérieurement. Pour cela, la couche barrière 130 peut être par exemple à base d'un matériau nitrure de silicium tel que du Si₃N₄.

La couche barrière 130 peut être déposée de manière conforme sur l'ensemble des transistors T₁ et T₂ et à recouvrir les grilles 108a, 108b ainsi que les zones semi-conductrices 125, 126, 115, 116 formées de chaque côté des grilles 108a, 108b.

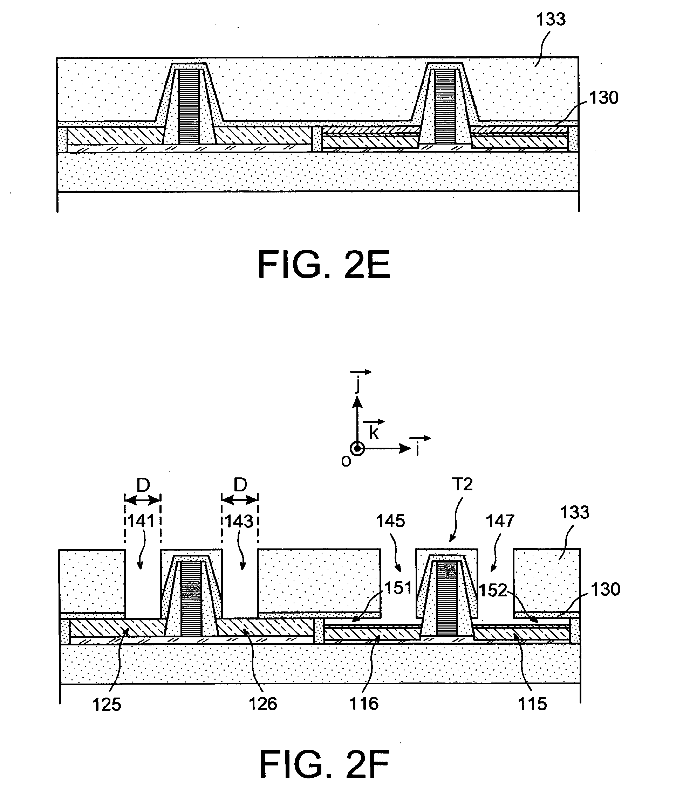

Puis, on forme une couche de matériau diélectrique 133 de manière à recouvrir les grilles 108a, 108b. On peut aplanir ensuite cette couche de matériau diélectrique 133, par exemple par un procédé de polissage mécano-chimique. Le matériau diélectrique 133 peut être choisi de manière à pouvoir être gravé sélectivement vis-à-vis de celui de la couche barrière 130. Le matériau diélectrique 133 peut être par exemple du SiO₂ lorsque la couche barrière 130 est à base d'un nitrure de silicium SiₓN_{y}, tel que du Si₃N₄ (Figure 2E).

On réalise ensuite des ouvertures 141, 143, 145, 147, traversant les couches 130 et 133, et qui sont destinées à accueillir des plots de contact de source et de drain du premier transistor T₁ et du deuxième transistor T₂. Cela peut être effectué par gravure sélective de la couche de matériau diélectrique 133 avec arrêt sur la couche barrière 130. Les ouvertures 141, 143 destinées à accueillir des plots de contact de source et de drain du premier transistor T₁ peuvent avoir un diamètre D (défini comme sur la figure 2F comme la plus petite dimension dans un plan parallèle au plan [O; *̅i̅*̅ ; *̅j̅*̅ ] du repère orthogonal [O*; i̅ ; j̅ ; k̅* ] ) compris par exemple entre 10 et 50 nanomètres, en particulier lorsque la grille du premier transistor a une dimension critique ou une largeur inférieure à 20 nanomètres.

Puis, on prolonge les ouvertures 141, 143, 145, 147, en réalisant une gravure de la couche barrière 130, avec arrêt sur la couche sacrificielle 117 (variante illustrée sur la figure 2F), ou éventuellement sur la couche d'arrêt de gravure 118 (variante non représentée). Cette gravure de la couche barrière 130 peut être réalisée par exemple à l'aide de H₃PO₄ lors que la couche barrière est à base de SiₓN_{y}.

La couche sacrificielle 117 est également retirée. Le retrait de la couche sacrificielle 117 peut être réalisé par exemple par gravure à l'aide d'une solution de TMAH.

Ce retrait conduit à la formation de cavités 151, 152 entre la couche barrière 130 et les zones semi-conductrices 115, 116 du deuxième transistor T₂. Le volume de ces cavités 151, 152, qui dépend notamment de l'épaisseur de la couche sacrificielle, peut être prévu en fonction d'une étape de siliciuration destinée à être réalisée ultérieurement.

Dans le cas où le matériau de la couche barrière 130 est prévu également de manière à contraindre le premier transistor T₁, le retrait de la couche sacrificielle 118 permet un relâchement de la contrainte qui était exercée par cette couche barrière 130 sur le deuxième transistor T₂ de type NMOS (Figure 2F).

La couche sacrificielle 118 peut être par exemple à base de Si tandis que la couche d'arrêt peut être à base de SiₓGe_{y}. Il est dans ce cas possible de graver cette couche sacrificielle 118 à l'aide d'une solution à base de TMAH, par exemple une solution contenant 25% de TMAH afin d'obtenir une sélectivité de l'ordre de 30 entre le silicium et du Si_{0.7}Ge_{0.3} de la couche d'arrêt 117. Ainsi, avec une telle sélectivité, le retrait d'une couche sacrificielle 118 de Si d'une épaisseur par exemple de l'ordre de 30 nm engendre une consommation du Si_{0.7}Ge_{0.3} de la couche d'arrêt 117 d'au plus 1 nm.

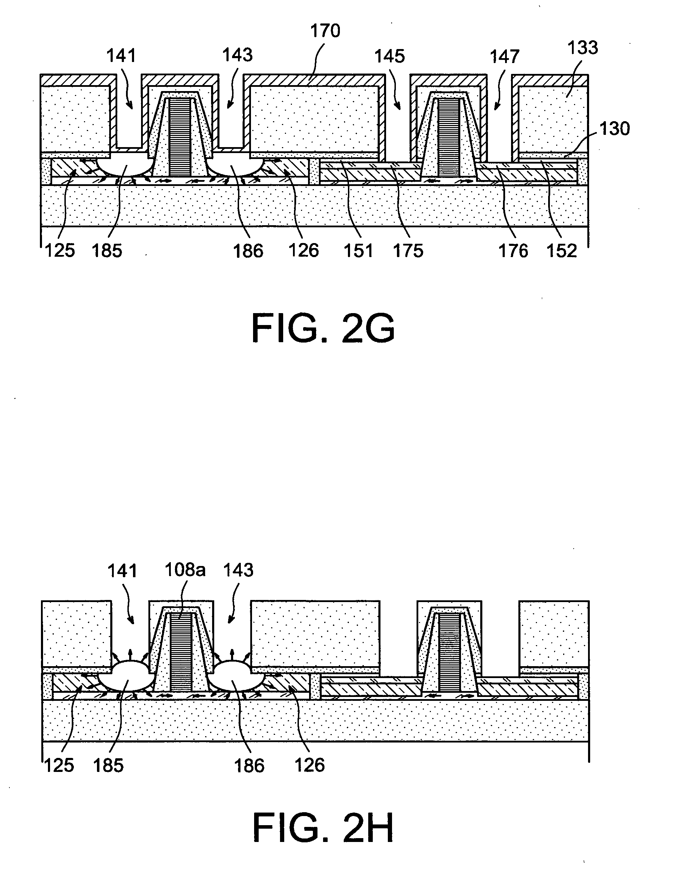

On effectue ensuite une siliciuration des zones semi-conductrices 115 et 116 dévoilées par les ouvertures 145, 147, formées de part et d'autre de la grille 108b du deuxième transistor T₂, ainsi que des zones semi-conductrices 125 et 126 dévoilées par les ouvertures 141, 143 formées de part et d'autre de la grille 108a du premier transistor T1 (figure 2G).

Cette siliciuration peut être réalisée par dépôt d'un matériau métallique 170 réagissant avec le matériau semi-conducteur respectif des zones semi-conductrices 115, 116 d'une part et 125 et 126 d'autre part.

Le matériau métallique 170 peut être constitué d'un métal ou d'un alliage de métaux choisi(s) parmi un ou plusieurs des métaux de transition ou les terre-rares suivants : nickel, palladium, platine, titane, Cobalt, Erbium, Ytterbium ou un alliage de ceux-ci, peut être mis en oeuvre. Le dépôt peut être non conforme, de sorte que l'épaisseur maximale de matière déposée se trouve en surface sur des zones parallèles au plan principal du substrat 100 (défini comme sur la figure 2B dans une direction parallèle au vecteur *̅j̅*̅ du repère orthogonal [O*; i̅ ; j̅ ; k̅* ] ) et au fond des ouvertures 141, 143, 145, 147, tandis que l'épaisseur de matière déposée est minimale sur les parois des ouvertures 141, 143, 145, 147. Le dépôt peut être par exemple de type PVD (PVD pour « Physical Vapor Deposition »), selon une épaisseur de métal qui peut être comprise par exemple entre 1 nm et 10 nm, par exemple de l'ordre de 5 nm.

Au niveau du deuxième transistor T₂, le matériau métallique 170 peut être déposé dans les ouvertures 145, 147 de manière à ne remplir que partiellement les cavités 151, 152.

Un ou plusieurs recuit(s) de siliciuration peut ou peuvent être ensuite réalisé(s) par un procédé de recuit rapide (communément appelé en anglais « *Rapide Thermal Process* » ou « RT ») à une température comprise par exemple entre 150°C et 800°C et par exemple préférentiellement entre 190°C et 400°C conduit à la réaction entre le silicium et le métal formant un siliciure (Figure 2G).

Lors de la siliciuration, des zones de siliciure 175, 176, 185, 186 sont formées par diffusion réactive entre le métal et le semi-conducteur et contribuent à une augmentation locale de volume.

Cela entraine, au fond des ouvertures 141, 143, réalisées de part et d'autre de la grille 108a du premier transistor T₁, l'apparition de contraintes en compression au niveau des zones 185, 186 d'alliage métal/semi-conducteur. Les zones 185, 186 d'alliage métal/semi-conducteur peuvent exercer une contrainte au niveau des zones destinées à jouer le rôle de sources et de drains du premier transistor T₁ et des espaceurs, cette contrainte se répercutant au niveau du canal du premier transistor T₁. La présence d'une couche barrière 130 sur les zones semi-conductrices 125, 126 permet de confiner le siliciure, et permet d'empêcher une diffusion de métal et une expansion des zones siliciurées dans un espace situé au-delà de la face de cette couche barrière 130 qui n'est pas en contact avec les premières zone semi-conductrices 125, 126. La couche barrière 130 permet ainsi de maintenir voire d'accroitre la contrainte formée par siliciuration par un effet de confinement du siliciure. La taille des ouvertures 141, 143 réalisées de part et d'autre du premier transistor T₁ est de préférence choisie suffisamment faible pour permettre de conserver la contrainte induite par siliciuration. Les ouvertures 141, 143 peuvent ainsi avoir un diamètre D1 compris entre 10 et 50 nanomètres, en particulier lorsque la grille du premier transistor a une dimension critique ou une largeur inférieure à 20 nanomètres.

Lors de cette siliciuration des zones siliciurées 175, 176 sont également formées au niveau des zones semi-conductrices destinées à jouer le rôle de sources et drains du deuxième transistor T2 de type nMOS.

Malgré une augmentation de volume des zones siliciurées 175, 176, les cavités 151, 152 précédemment formées par gravure de la couche sacrificielle 117 sont prévues de sorte qu'après siliciuration, un espace restant est maintenu entre les zones siliciurées 175, 176 et la couche de contrainte 130. Les cavités 151, 152 ne sont ainsi, de préférence, pas totalement remplies.

On limite ainsi, voire on empêche des contraintes en compression sur la zone de canal du deuxième transistor T₂ de type NMOS (figure 2G) en permettant la relaxation des zones siliciurées.

Une contrainte supérieure à -2 GPa peut être mise en oeuvre sur le premier transistor T₁.

Dans le cas, par exemple, où l'on forme un siliciure à base de Pd₂Si, la variation de volume entre le siliciure et le silicium peut être de l'ordre de 209%, ce qui peut induire une contrainte triaxiale de - 50 GPa.

Pour des volumes donnés de matériau semi-conducteur et de matériau métallique déposé, une contrainte maximale peut être atteinte lorsque tout le matériau métallique 170 déposé a été consommé.

Une relaxation de la contrainte peut être prévue et modulée en fonction du temps prévu pour le recuit.

Il est donc possible de contrôler le niveau de contrainte au niveau des zones siliciurées 185, 186 en ajustant le temps de recuit ou/et la température de recuit. Ce niveau de contrainte dépend également du type de matériau métallique 170 ainsi que des volumes respectifs de matériau semi-conducteur des zones 125, 126 et du matériau métallique 170 déposé.

Le tableau ci-dessous donne des variations de volume lors d'une réaction de siliciuration à l'état solide avec des volumes normalisés par unité de métal.

| **Métal** | **Silicium** | **Siliciure** | **Siliciure / (métal +silicium)** | **Siliciure / espèce la moins mobile** |
|---|---|---|---|---|
| Ti | 2Si | TiSi₂ | 0.77 | TiSi₂ / Ti |
| 1.00 | 2.24 | 2.50 | | 2.50 |
| 2 Pd | Si | Pd₂Si | 0.84 | Pd₂Si / Si |
| 1.00 | 0.68 | 1.42 | | 2.09 |
| Pt | Si | PtSi | 0.84 | PtSi / Si |
| 1.00 | 1.35 | 1.98 | | 1.49 |
| 2 Co | Si | Co₂Si | 0.77 | Co₂Si / Si |
| 1.00 | 0.91 | 1.47 | | 1.47 |
| Ni. | Si | NiSi | 0.77 | NiSi / Si |
| 1.00 | 1.83 | 2.18 | | 1.20 |
| Ni | Si | NiSi₂ | 0.76 | NiSi₂ / Si |
| 1.00 | 3.66 | 3.59 | | 0.99 |
| Ta | 2Si | TaSi₂ | 0.75 | TaSi₂ / Ta |
| 1.00 | 2.21 | 2.40 | | |
| Mo | 2Si | MoSi₂ | 0.73 | MoSi₂ / Mo |
| 1.00 | 2.57 | 2.60 | | |
| W | 2Si | WSi₂ | 0.73 | WSi₂ / W |
| 1.00 | 2.52 | 2.58 | | |

Le choix du matériau métallique 170 déposé et du siliciure que l'on souhaite former, peut être également fait par exemple selon l'application prévue pour le dispositif à transistors, et/ou en fonction du noeud technologique, c'est-à-dire de la taille prévue pour les transistors du dispositif.

Par exemple, pour des noeuds technologique C0 = 45nm et C0 = 32nm, on peut être amené à choisir de réaliser des zones siliciurées de PtSi et de NiSi pour leur faible résistivité électrique.

Le choix du matériau métallique 170 ainsi que du siliciure que l'on forme peut dépendre également des difficultés de mise en oeuvre du procédé de réalisation par exemple des étapes de traitements thermiques associées, de nettoyage, de gravure à mettre en oeuvre.

Le choix du matériau métallique 170 peut être également fait selon un critère mécanique, c'est à dire en fonction de l'intensité de la contrainte que l'on souhaite exercer sur les zones 185, 186.

Pour cela, on pourra par exemple choisir un siliciure ayant de fortes propriétés élastiques, en termes de module d'young, la contrainte résultante étant le produit des propriétés élastiques par la déformation résiduelle induite par le changement de volume lors de la réaction de siliciuration.

Un autre critère mécanique peut être la faible relaxation de la couche pendant ou après sa formation. Le document"Influence of Si substrate orientation on stress development in Pd silicide films grown by solid-state reaction", . Gergaud, M. Megdiche, O. Thomas and B. Chenevier, , Appl Phys. Lett. 83 (2003) 1334-1336 montre un exemple de relaxation variable et de de contrainte finale variable en fonction d'une microstructure du siliciure.

La formation d'un siliciure par réaction entre le matériau métallique 170 et du silicium conduit à une consommation en silicium différente selon le matériau métallique 170 déposé. L'épaisseur du matériau métallique 170 peut être ainsi prévue en fonction de cette consommation.

Comme cela a été indiqué auparavant, en ajustant le temps de recuit, on peut ajuster la relaxation du siliciure formé.

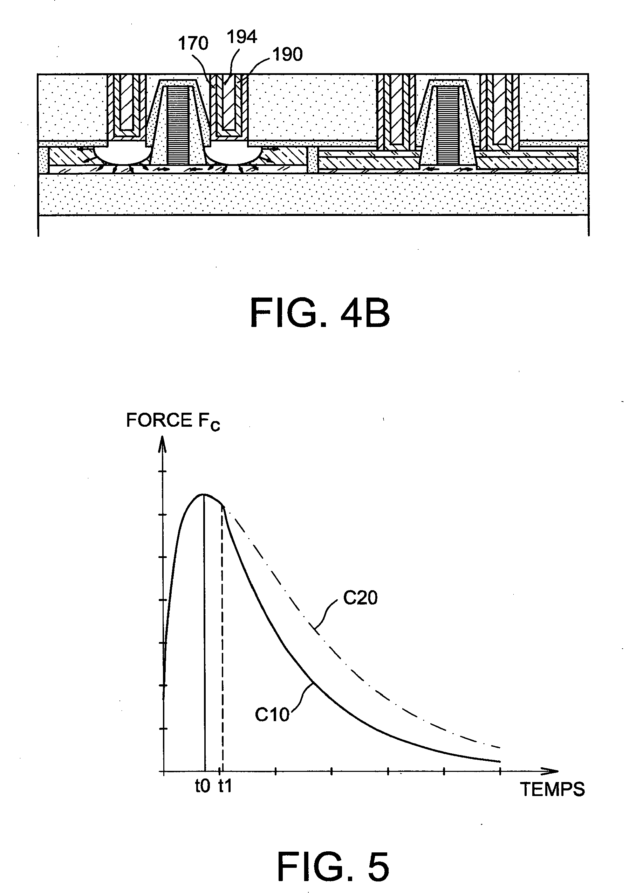

Sur la figure 5, un exemple de courbe C10, représentative d'une variation d'une force dans une zone de siliciure lors de sa formation en fonction du temps de recuit, est donné.

Ladite force correspond à la somme de la force induite par le changement de volume du silicium en siliciure c'est à dire la contrainte de formation du siliciure, et de la relaxation de cette force c'est-à-dire de la contrainte initiale.

Dès l'instant t = 0 de départ du recuit, la force augmente avec le volume de siliciure formé. Cette force passe par un maximum à un temps de recuit t = t0 lorsque l'augmentation de force apportée par chaque nouvel élément de volume de siliciure est inférieure en valeur absolue à la diminution de force par relaxation de l'ensemble du volume de siliciure déjà formé depuis l'instant de départ t = 0.

Sur la figure 5, une portion de courbe C20 en traits discontinus illustre le cas théorique d'un volume de métal infini.

Dans le cas d'un volume fini de métal, lorsque tout le métal est consommé à un instant t = t1, seule la relaxation est alors active. Autrement dit, le choix de la force appliquée au canal pourra être fixé avec le temps de recuit.

Dans le cas de la réalisation d'une couche métallique très mince, en particulier inférieure à 20 nm, les temps t0 et t1 sont très proches. Ainsi, la fin de la consommation du matériau métallique peut être prévue et constituer le temps de référence au recuit de siliciuration à partir duquel le niveau de contrainte peut être modifié.

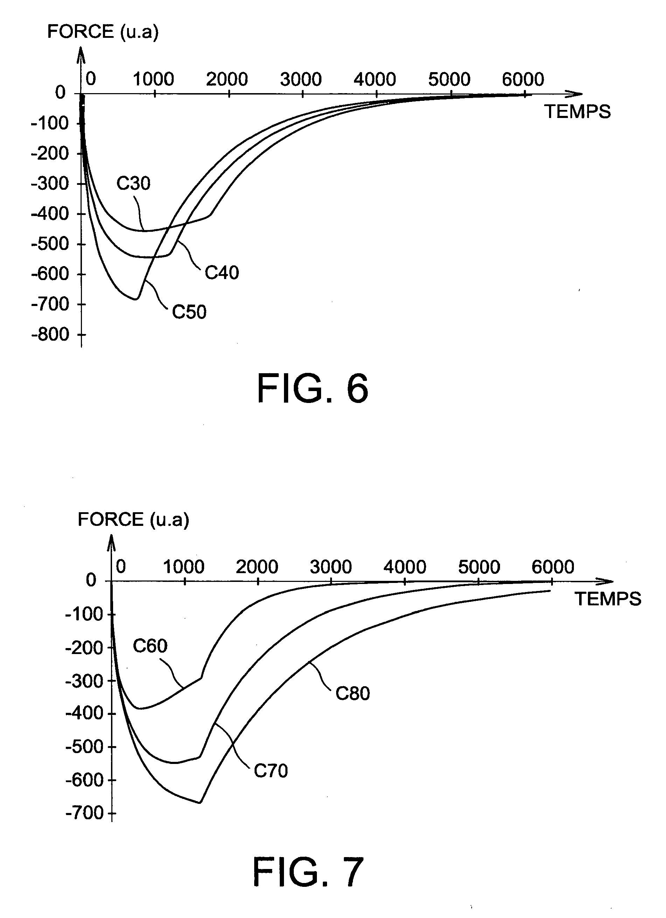

Sur la figure 6, des courbes d'évolution C30, C40, C50 sont représentatives de forces dans un siliciure au cours de sa croissance pour différentes valeurs de coefficients de diffusion et égales respectivement à Kd, 2*Kd, 3*Kd, Kd étant un coefficient de diffusion, à taux de relaxation τ constant. Une définition des ces paramètres et des exemples de valeurs expérimentales sont données dans le document référence . P. Gergaud, O. Thomas and B. Chenevier, J. Appl. Phys. 94 (4) (2003) 1584-1591 et dans la référence . S. L. Zhang and F. M. d'Heurle, Thin Solid Films 213, 34 ∼1992.

Sur la figure 7, des courbes d'évolution C60, C70, C80 sont représentatives de forces dans un siliciure au cours de sa croissance pour différentes valeurs de taux de relaxation égales respectivement à τ, 2*τ, 3*τ, à coefficient de diffusion Kd constant.

Une fois les zones siliciurées 175, 176, 185, 186 réalisées, on peut effectuer un retrait sélectif du métal n'ayant pas réagit.

Le cas d'un retrait sélectif est illustré sur la figure 2H. Le métal en excès est sélectivement retiré par immersion dans une solution chimique chauffée dont la composition, les concentrations et la température sont choisies en fonction du métal précédemment déposé.

Le temps d'immersion est ajusté afin de permette à la solution d'accéder au métal au fond des ouvertures 141, 143, 145, 147. Par exemple, lorsque le métal déposé est du Ni, la solution utilisée peut être par exemple du Caro (H₂SO₄/H₂O₂).

Une couche barrière de diffusion 190 peut être ensuite déposée dans les ouvertures 141, 143, 145, 147. Cette couche barrière de diffusion 190 peut être par exemple à base de TiN ou de TaN et avoir une épaisseur comprise par exemple entre 1 nm et 10 nm.

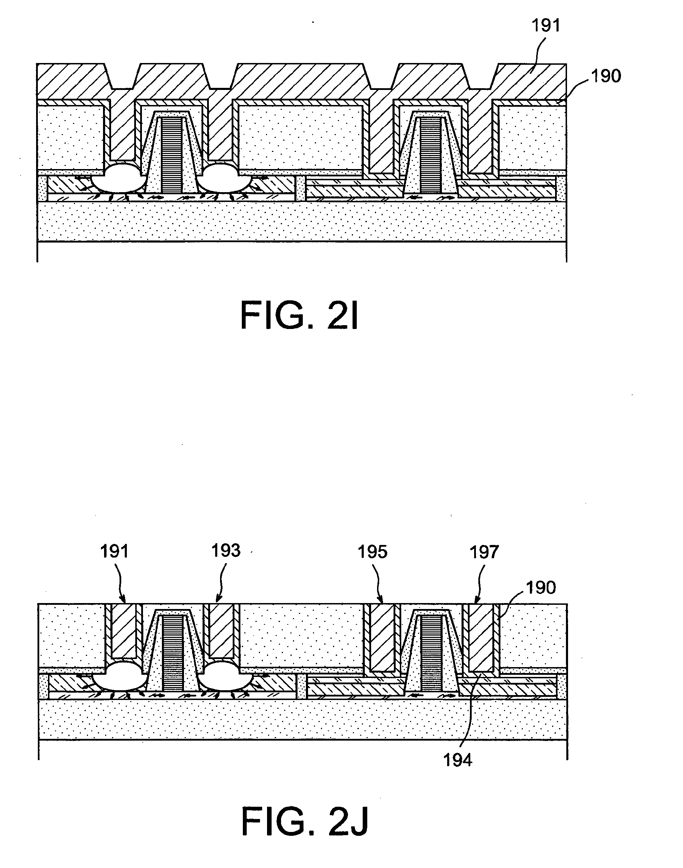

Un dépôt d'un matériau métallique 194 est ensuite effectué de manière à combler les ouvertures 141, 143, 145, 147. Ce matériau métallique 194 peut être par exemple du Tungstène, ou du Cuivre (Figure 2I).

Le matériau métallique 194 en excès ainsi que la couche barrière de diffusion 190 sont ensuite ôtés lors d'étapes de polissage mécano-chimique avec un arrêt sur la couche de matériau diélectrique 133. Cela permet de former des plots de contact 191, 193, 195, 197 (Figure 2J) qui peuvent être prévus pour connecter les transistors T₁, T₂ avec un ou plusieurs niveaux d'interconnections.

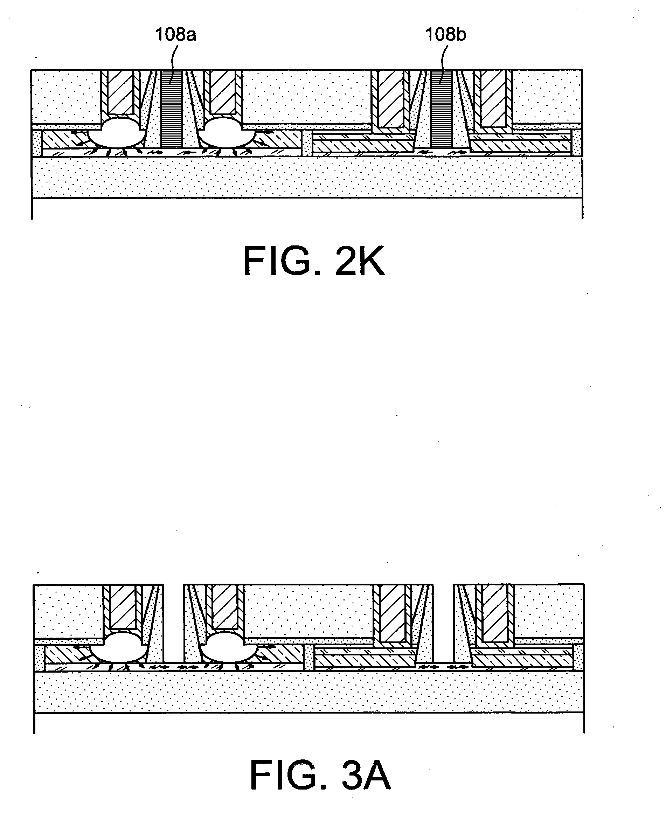

Selon une possibilité de mise en oeuvre, le procédé peut comprendre en outre une étape consistant à dévoiler le dessus de la grille 108a du premier transistor T1 ainsi que celui de la grille 108b du deuxième transistor T2 (figure 2K).

Un accès aux grilles 108a, 108b est ainsi réalisé. On peut ensuite former un ou plusieurs niveaux d'interconnexion par-dessus les transistors T₁ et T₂.

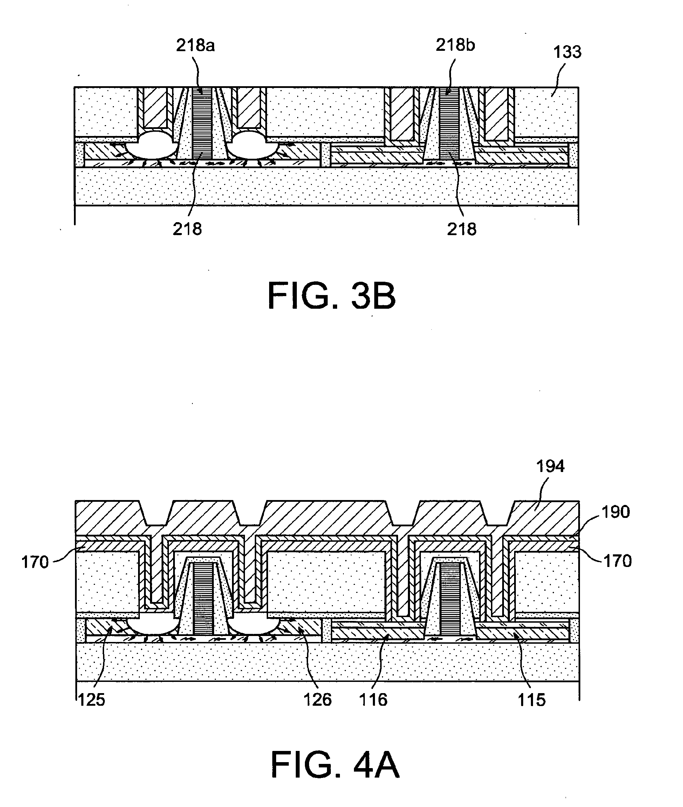

Selon une variante illustrée sur les figures 3A et 3B, une fois les étapes précédemment décrites ont été réalisées, on peut ensuite retirer les grilles 108a et 108b qui, dans ce cas, ont jouées le rôle de grilles sacrificielles ou de grilles factices (figure 3A). On remplace ensuite ces grilles sacrificielles ou factices par d'autres grilles 218a et 218b formées en un autre matériau de grille.

Pour cette variante, les grilles sacrificielles 108a, 108b peuvent être formées d'un matériau semi-conducteur, par exemple tel que du polysilicium.

Le remplacement des grilles 108a, 108b peut être effectué par dépôt d'un autre matériau 218 de grille, tel qu'un métal ou un empilement de plusieurs métaux. Cela peut être réalisé par dépôt puis retrait d'un éventuel excédent par polissage mécano-chimique avec arrêt sur la couche de matériau diélectrique 133.

Cette variante de réalisation est effectuée après la formation des zones siliciurées et peut conduire à une redistribution des contraintes préférentiellement au niveau des zones de canal des transistors T₁ et T₂.

Une autre variante de réalisation est donnée sur les figures 4A-4B.

Pour cette variante, le métal 170 déposé dans les ouvertures 141, 143, 145, 147 pour effectuer une siliciuration des zones semi-conductrices 115, 116, 125, 126, est conservé.

Une couche barrière de diffusion 190, par exemple à base de TaN ou de TiN et d'une épaisseur comprise par exemple entre 1 nm et 10 nm, est ensuite déposée. Puis, un matériau métallique 194 tel que par exemple du tungstène, ou du cuivre est déposé afin de combler les ouvertures 141, 143, 145, 147 (figure 4A).

Ensuite, les couches de métal 170, de barrière 190 et de matériau métallique 194 sont ôtées de la surface de la couche de matériau diélectrique par exemple par polissage mécano-chimique avec un arrêt sur le diélectrique (figure 4B).

## Revendications

1. Procédé de réalisation d'un dispositif microélectronique à transistors comprenant des étapes consistant à :
a) former une couche barrière à base d'un matériau donné sur des premières zones semi-conductrices (125, 126) situées de part et d'autre d'un premier bloc de grille d'un premier transistor et sur des deuxièmes zones semi-conductrices (115, 116) situées de part et d'autre d'un deuxième bloc de grille d'un deuxième transistor, ledit matériau donné étant différent de celui desdites premières zones semi-conductrices, une couche sacrificielle (118) étant prévue entre ladite couche barrière (130) de matériau donné (130) et lesdites deuxièmes zones semi-conductrices (115, 116) du transistor (T2) du deuxième type,
b) former des ouvertures (141, 143, 145, 147) traversant la couche barrière (130), une ou plusieurs ouvertures données (141, 143) dévoilant les premières zones semi-conductrices, une ou plusieurs autres ouvertures (145, 147) dévoilent les deuxièmes zones semi-conductrices (115,116), le procédé comprenant en outre entre l'étape b) et l'étape c), le retrait de la couche sacrificielle (118) par gravure à travers lesdites autres ouvertures (145, 147),
c) déposer un matériau métallique (170) à travers lesdites ouvertures (141, 143, 145, 147), suivi d'un recuit, de manière à former des zones (175, 176, 185, 186) d'alliage de métal et de semi-conducteur, le volume de matériau métallique déposé sur les premières zones semi-conductrices (125, 126), ainsi que la durée du recuit étant choisis de manière à former des premières zones d'alliage de métal et de semi-conducteur (185,186) exerçant une contrainte en compression sur une zone de canal dudit premier transistor (T1), à l'étape c), ledit dépôt métallique et ledit recuit étant réalisés de manière à former des deuxièmes zones d'alliage de métal et de semi-conducteur (175, 176) comblant partiellement lesdites cavités (151, 152), un espace (161) étant conservé entre lesdites deuxièmes zones d'alliage de métal et de semi-conducteur (175, 176) et ladite couche barrière (130).

2. Procédé de réalisation d'un dispositif microélectronique selon la revendication 1, le matériau donné étant prévu pour empêcher une diffusion de métal lors de l'étape c).

3. Procédé selon l'une des revendications 1 ou 2, dans lequel le premier bloc de grille (108a) et le deuxième bloc de grille (108b) reposent sur une couche semi-conductrice (103), les premières zones semi-conductrices (125, 126) et/ou les deuxièmes zones semi-conductrices (115, 116) étant formées par croissance sur ladite couche semi-conductrice (103).

4. Procédé selon la revendication 3, le procédé comprenant en outre, préalablement à ladite croissance : un amincissement de ladite couche semi-conductrice (103) dans des zones (104, 105) situées de part et d'autres dudit premier bloc de grille (108a) et/ou dudit deuxième bloc de grille (108b).

5. Procédé selon l'une des revendications 3 ou 4, les premières zones semi-conductrices (125, 126) étant formées d'un matériau semi-conducteur, tel que du SiGe, prévu pour contraindre en compression ladite couche semi-conductrice (103) sur laquelle repose ledit premier bloc de grille (108a).

6. Procédé selon l'une des revendications 3 à 5, les deuxièmes zones semi-conductrices (115, 116) étant formées d'un matériau semi-conducteur, tel que du SiC, prévu pour contraindre en tension ladite couche semi-conductrice (103) sur laquelle repose ledit deuxième bloc de grille (108b).

7. Procédé selon l'une des revendications 1 à 6, dans lequel ladite couche barrière (130) formée à l'étape a) sur le premier bloc de grille est prévue de manière à contraindre le premier transistor (T1).

8. Procédé selon l'une des revendications 1 à 7, dans lequel ladite couche barrière (130) est à base d'un matériau diélectrique, en particulier du nitrure de silicium Si₃N₄.

9. Procédé selon l'une des revendications 1 à 8, dans lequel la couche barrière (130) est séparée desdites deuxièmes zones semi-conductrices par une couche d'arrêt de gravure (117), le retrait à l'étape c) de la couche sacrificielle (118) par gravure à travers lesdites ouvertures données (145, 147) étant réalisé jusqu'à atteindre ladite couche d'arrêt de gravure (118).

10. Procédé selon l'une des revendications 1 à 9, comprenant en outre entre l'étape a) et l'étape b), des étapes de :
- dépôt d'au moins une couche isolante (133) sur la couche barrière (130),
- formation de trous traversant la dite couche isolante et dévoilant ladite couche barrière (130) par gravure sélective de ladite couche isolante vis-à-vis de ladite couche barrière (130).

11. Procédé selon l'une des revendications 1 à 10, dans lequel le premier bloc de grille (108a) et/ou ledit deuxième bloc de grille (108b) sont à base d'au moins un matériau sacrificiel, le procédé comprenant en outre, après l'étape c), des étapes de :
- retrait de la couche barrière (130) sur ledit premier bloc (108a) de grille et/ou sur ledit deuxième bloc (108b) de grille de manière à dévoiler ledit matériau sacrificiel,
- retrait dudit matériau sacrificiel,
- remplacement dudit matériau sacrificiel par au moins un autre matériau de grille.

12. Dispositif microélectronique à transistor(s) comprenant : des premières zones semi-conductrices (125, 126) situées de part et d'autre d'un premier bloc de grille d'un premier transistor recouvertes d'une couche barrière à base d'un matériau donné sur ledit matériau donné différent de celui desdites premières zones semi-conductrices, des ouvertures (141, 143, 145, 147) traversant la couche barrière (130), une ou plusieurs ouvertures données (141, 143) dévoilant les premières zones semi-conductrices, des premières zones d'alliage de métal et de semi-conducteur (185,186) étant formées à travers les ouvertures et agencées de manière à exercer une contrainte en compression sur une zone de canal dudit premier transistor (T1), dans lequel
ladite couche barrière (130) recouvre également des deuxièmes zones semi-conductrices (115, 116) situées de part et d'autre d'un deuxième bloc de grille d'un deuxième transistor, une ou plusieurs ouvertures données (141, 143) formées dans la couche barrière dévoilant les deuxièmes zones semi-conductrices (115,116), un espace (161) étant prévu entre lesdites deuxièmes zones d'alliage de métal et de semi-conducteur (175, 176) et ladite couche barrière (130).

13. Dispositif microélectronique selon la revendication 12, les deuxièmes zones semi-conductrices (115, 116) étant formées d'un matériau semi-conducteur, tel que du SiC, prévu pour contraindre en tension une couche semi-conductrice (103) sur laquelle repose ledit deuxième bloc de grille (108b).

## Patentansprüche

1. Verfahren zur Herstellung einer mikroelektronischen Einrichtung mit Transistoren, umfassend Schritte, die darin bestehen:
a) eine Barrieren-Schicht auf Basis eines gegebenen Materials auf ersten halbleitenden Bereichen (125, 126) zu bilden, die sich auf beiden Seiten eines ersten Gate-Blocks von einem ersten Transistor befinden, und auf zweiten halbleitenden Bereichen (115, 116), die sich auf beiden Seiten eines zweiten Gate-Blocks von einem zweiten Transistor befinden, wobei das gegebene Material sich von demjenigen der ersten halbleitenden Bereiche unterscheidet, wobei eine Opferschicht (118) zwischen der Barrieren-Schicht (130) aus dem gegebenen Material (130) und den zweiten halbleitenden Bereichen (115, 116) des Transistors (T2) vom zweiten Typ vorgesehen ist,
b) Öffnungen (141, 143, 145, 147) zu bilden, welche die Barrieren-Schicht (130) durchqueren, wobei eine oder mehrere gegebene Öffnungen (141, 143) die ersten halbleitenden Bereiche freilegen, wobei eine oder mehrere andere Öffnungen (145, 147) die zweiten halbleitenden Bereiche (115, 116) freilegen, wobei das Verfahren weiterhin, zwischen dem Schritt b) und dem Schritt c), das Entfernen der Opferschicht (118) durch Ätzen durch die anderen Öffnungen (145, 147) hindurch umfasst,
c) ein metallisches Material (170) durch die Öffnungen (141, 143, 145, 147) hindurch aufzubringen, gefolgt von einem Tempern, so dass Metall-Halbleiter-Legierung-Bereiche (175, 176, 185, 186) gebildet werden, wobei das Volumen des auf die ersten halbleitenden Bereiche (125, 126) aufgebrachten metallischen Materials wie auch die Dauer des Temperns so ausgewählt werden, dass erste Metali-Halbleiter-Legierung-Bereiche (185, 186) gebildet werden, welche eine Druckbelastung auf einen Kanal-Bereich von dem ersten Transistor (T1) ausüben, im Schritt c), wobei das metallische Aufbringen und das Tempern so ausgeführt werden, dass zweite Metall-Halbleiter-Legierung-Bereiche (175, 176) gebildet werden welche die Kavitäten (151, 152) teilweise füllen, wobei ein Raum (161) zwischen den zweiten Metall-Halbleiter-Legierung-Bereichen (175, 176) und der Barrieren-Schicht (130) beibehalten wird.

2. Verfahren zur Herstellung einer mikroelektronischen Einrichtung nach Anspruch 1, wobei das gegebene Material dazu vorgesehen ist, im Schritt c) eine Diffusion von Metall zu verhindern.

3. Verfahren nach einem der Ansprüche 1 oder 2, wobei der erste Gate-Block (108a) und der zweite Gate-Block (108b) auf einer halbleitenden Schicht (103) ruhen, wobei die ersten halbleitenden Bereiche (125, 126) und/oder die zweiten halbleitenden Bereiche (115, 116) durch Wachsen auf der halbleitenden Schicht (103) gebildet werden.

4. Verfahren nach Anspruch 3, wobei das Verfahren weiterhin vor dem Wachsen umfasst: eine Verdünnung der halbleitenden Schicht (103) in Bereichen (104, 105), die sich zu beiden Seiten von dem ersten Gate-Block (1 08a) oder/und von dem zweiten Gate-Block (1 08b) befinden.

5. Verfahren nach einem der Ansprüche 3 oder 4, wobei die ersten halbleitenden Bereiche (125, 126) aus einem halbleitenden Material wie zum Beispiel SiGe gebildet werden, das dazu vorgesehen ist, eine Druckbelastung auf die halbleitende Schicht (103) auszuüben, auf welcher der erste Gate-Block (108a) ruht.

6. Verfahren nach einem der Ansprüche 3 bis 5, wobei die zweiten halbleitenden Bereiche (115, 116) aus einem halbleitenden Material wie zum Beispiel SiC gebildet werden, das dazu vorgesehen ist, eine Zugbelastung auf die halbleitende Schicht (103) auszuüben, auf welcher der zweite Gate-Block (108b) ruht.

7. Verfahren nach einem der Ansprüche 1 bis 6, wobei die beim Schritt a) auf dem ersten Gate-Block gebildete Barrieren-Schicht (130) so vorgesehen ist, dass sie den ersten Transistor (T1) belastet.

8. Verfahren nach einem der Ansprüche 1 bis 7, wobei die Barrieren-Schicht (130) auf einem dielektrischen Material basiert, insbesondere auf Siliziumnitrid Si₃N₄.

9. Verfahren nach einem der Ansprüche 1 bis 8, wobei die Barrieren-Schicht (130) von den zweiten halbleitenden Bereichen durch eine Ätz-Stopp-Schicht (117) getrennt ist, wobei das Entfernen der Opferschicht (118) im Schritt c) durch Ätzen durch die gegebenen Öffnungen (145, 147) hindurch bis zum Erreichen der Ätz-Stopp-Schicht (118) ausgeführt wird.

10. Verfahren nach einem der Ansprüche 1 bis 9, weiterhin umfassend, zwischen dem Schritt a) und dem Schritt b), Schritte:
- wenigstens eine isolierende Schicht (133) auf der Barrieren-Schicht (130) aufzubringen,
- Löcher zu bilden, welche die isolierende Schicht durchqueren und die Barrieren-Schicht (130) freilegen, durch selektives Ätzen der isolierenden Schicht gegenüber der Barrieren-Schicht (130).

11. Verfahren nach einem der Ansprüche 1 bis 10, wobei der erste Gate-Block (108a) oder/und der zweite Gate-Block (108b) auf wenigstens einem Opfer-Material basieren, wobei das Verfahren weiterhin, nach dem Schritt c), Schritte umfasst:
- die Barrieren-Schicht (130) auf dem ersten Gate-Block (108a) oder/und auf dem zweiten Gate-Block (108b) zu entfernen, so dass das Opfer-Material freigelegt wird,
- das Opfer-Material zu entfernen,
- das Opfer-Material durch wenigstens ein anderes Gate-Material zu ersetzen.

12. Mikroelektronische Einrichtung mit Transistor(en), umfassend:
erste halbleitende Bereiche (125, 126), die sich zu beiden Seiten von einem ersten Gate-Block von einem ersten Transistor befinden, die mit einer Barrieren-Schicht auf Basis von einem gegebenen Material bedeckt sind, auf dem gegebenen Material, das sich von dem der ersten halbleitenden Bereiche unterscheidet, Öffnungen (141, 143, 145, 147), welche die Barrieren-Schicht (130) durchqueren, wobei eine oder mehrere gegebene Öffnungen (141, 143) die ersten halbleitenden Bereiche freilegen, wobei erste Metall-Halbleiter-Legierung-Bereiche (185, 186) durch die Öffnungen hindurch gebildet und so angeordnet sind, dass sie eine Druckbelastung auf einen Kanal-Bereich von dem ersten Transistor (T1) ausüben, wobei die Barrieren-Schicht (130) ebenfalls zweite halbleitende Bereiche (115, 116) abdeckt, die sich zu beiden Seiten von einem zweiten Gate-Block von einem zweiten Transistor befinden, wobei eine oder mehrere gegebene Öffnungen (141, 143), die in der Barrieren-Schicht gebildet sind, die zweiten halbleitenden Bereiche (115, 116) freilegen, wobei ein Raum (161) zwischen den zweiten Metall-Halbleiter-Legierung-Bereiehen (175, 176) und der Barrieren-Schicht (130) vorgesehen ist.

13. Mikroelektronische Einrichtung nach Anspruch 12, wobei die zweiten halbleitenden Bereiche (115, 116) aus einem halbleitenden Material wie zum Beispiel SiC gebildet sind, das dazu vorgesehen ist, eine Zugbelastung auf eine halbleitende Schicht (103) auszuüben, auf welcher der zweite Gate-Block (1 08b) ruht.

## Claims

1. A method for making a microelectronic transistor device comprising the following steps:
a) formation of a barrier layer based on a given material on first semiconducting zones located on each side of a first gate block of a first transistor and on second semiconducting layers located on each side of a second gate block of a second transistor, said given material being different from the material used in said first semiconducting zones, a sacrificial layer being provided between said given material layer and said second semiconducting zones of the transistor of the second type, b) form openings passing through the barrier layer, one or several given openings exposing the first semiconducting zones, one or several given openings expose the second semiconducting zones, the method further comprising between step b) and step c), the removal of the barrier layer by etching through said openings,
c) deposit a metallic material through said openings, followed by annealing, so as to form metal and semiconductor alloy zones, the volume of metallic material deposited on the first semiconducting zones, and the annealing duration being chosen so as to form first metal and semiconductor alloy zones applying a compressive strain on a channel zone of said first transistor, in step c), said metallic deposition and said annealing being done so as to form second metal and semiconductor alloy zones partially filling in said cavities, a space being maintained between said second metal and semiconductor alloy zones s and said barrier layer.

2. A method for making a microelectronic device according to claim 1, the given material being designed to prevent metal diffusion during step c).

3. A method according to claim 1 or 2, wherein the first gate block and the second gate block are supported on a semiconducting layer, the first semiconducting zones and/or the second semiconducting zones being formed by growth on said semiconducting layer.

4. A Method according to claim 3, the method also comprising, prior to said growth: thinning of said semiconducting layer in zones located on each side of said first gate block and/or said second gate block.

5. A Method according to any of claims 3 or 4, the first semiconducting zones being formed of a semiconducting material, such as SiGe, designed to compressively strain said semiconducting layer on which said first gate block is supported.

6. A method according to any of claims 3 to 5, the second semiconducting zones being formed from a semiconducting material, such as SiC, designed to apply a tensile strain on said semiconducting layer on which said second gate block is supported.

7. A method according to any of claims 1 two 6, wherein said barrier layer formed in step a) on the first gate block is designed to apply strain on the first transistor type.

8. A method according to any of claims 1 to 7, wherein said barrier layer is based on a dielectric material, in particular silicon nitride Si₃N₄.

9. A method according to any of claims 1 to 8, wherein said barrier layer is separated from said second semiconducting zones by an etching stop layer, removal of the sacrificial layer in step c) by etching through said given openings being done until reaching said etching stop layer.

10. A method according to any of claims 1 to 9, also comprising the following steps between step a) and step b):
- deposition of at least one insulating layer on the barrier layer,
- formation of holes passing through said insulating layer and exposing said barrier layer by selective etching of said insulating layer relative to said barrier layer.

11. A method according to any of claims 1 to 10, wherein the first gate block and/or said second gate block are based on at least one sacrificial material, the method also comprising the following steps, after step c):
- removal of the barrier layer on said first gate block and/or said second gate block so as to expose said sacrificial material,
- removal of said sacrificial material,
- replaying said sacrificial material by at least one other gate material.

12. A microelectronic device with transistor(s) comprising first semiconducting zones located on each side of a first gate block in a first transistor, covered with a barrier layer based on a given material on said given material different from that of said first semiconducting zones, openings passing through the barrier layer, one or several given openings exposing the first semiconducting zones, first metal and semiconductor alloy zones being formed through openings and arranged so as to apply a strain on a channel zone of said first transistor, in compression, wherein said barrier layer also covers second semiconducting zones located on each side of a second gate block of a second transistor, one or several given openings being formed in the barrier layer exposing the second semiconducting zones, a space being provided between said second metal and semiconductor alloy zones and said barrier layer.

13. A microelectronic device according to claim 12, the second semiconducting zones being formed from a semiconducting material such as SiC, designed to apply a tensile strain on said semiconducting layer on which said second gate block is supported.
